(19)

**Europäisches Patentamt**

**European Patent Office**

**Office européen des brevets**

(11) **EP 4 607 229 A1**

(12) **EUROPEAN PATENT APPLICATION**

(43) Date of publication:
**27.08.2025 Bulletin 2025/35**

(21) Application number: **24159011.6**

(22) Date of filing: **22.02.2024**

(51) International Patent Classification (IPC):
**G01R 33/56** (2006.01)     *G01R 33/48* (2006.01)
**G01R 33/561** (2006.01)     *G01R 33/563* (2006.01)

(52) Cooperative Patent Classification (CPC):
**G01R 33/5608;** G01R 33/4816; G01R 33/5614;
G01R 33/56341

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Koninklijke Philips N.V.
5656 AG Eindhoven (NL)**

(72) Inventor: **KATSCHER, Ulrich Wolfgang
Eindhoven (NL)**

(74) Representative: **Philips Intellectual Property &
Standards
High Tech Campus 52
5656 AG Eindhoven (NL)**

(54) **SYSTEMS AND METHODS OF ANISOTROPY EVALUATION WITH ELECTRICAL PROPERTIES TOMOGRAPHY**

(57) Methods and systems for electrical properties tomography imaging are presented. Partial electrical properties for at least one portion of the body are derived based on magnetic resonance imaging data, and aniso-tropy of electrical properties is displayed accordingly. The electrical properties may comprise conductivity and/or permittivity.

Fig. 3

## Description

### TECHNICAL FIELD

The subject-matter described herein relates to electrical properties tomography through magnetic resonance imaging.

### BACKGROUND

Quantitative magnetic resonance imaging, in particular Electrical Properties Tomography (EPT), is one of the imaging techniques that potentially could be used for non-invasive diagnosis of various diseases and/or for assessment of stages in disease evolution.

EPT is an imaging method that uses a magnetic resonance (MR) system to non-invasively derive spatial distribution of conductivity $\sigma$ and permittivity $\varepsilon$ of an imaged subject from measurement of magnitude and phase of the radiofrequency (RF) transmit field B1 (i.e. measurement of complex B1 map), followed by a subsequent postprocessing of the complex B1 map according to Maxwell's equations. An extensive review of EPT is to be found in Leijsen R., et al., "Electrical Properties Tomography: A Methodological Review", Diagnostics, 11, 176, (2021); https://doi.org/10.3390/diagnostics11020176, which is hereby incorporated by reference in its entirety.

The information included in this Background section of the specification, including any references cited herein and any description or discussion thereof, is included for technical reference purposes only and is not to be regarded as subject-matter by which the scope of the disclosure is to be bound.

### SUMMARY

The objective of the invention is to differentiate electrical properties along various directions, which provides additional and/or improved diagnostic value to electrical properties tomography.

In an aspect of the invention a method of electrical properties tomography imaging is provided, comprising:

> receiving magnetic resonance imaging data of at least one portion of a body;
> deriving partial electrical properties based on the magnetic resonance imaging data;
> outputting to a display screen anisotropy of electrical properties for the at least one portion of the body based on the partial electrical properties.

In an embodiment the method may further comprise:

> providing an image segmentation comprising one or more anatomical regions within the magnetic resonance imaging data in response to inputting the magnetic resonance imaging data into an image segmentation algorithm;
> wherein outputting the anisotropy of electrical properties is for the provided image segmentation.

In an embodiment of the method, providing image segmentation comprises dividing field of view of the anatomy in subsections of fields of view and wherein the one or more anatomical regions are segmented based on selection of at least one of the subsections of fields of view.

In an embodiment, the one or more anatomical regions are selectable by a user through a user interface. Alternatively or additionally, the one or more anatomical regions are part of a predetermined set selectable by the user through a menu of the user interface.

In an embodiment, outputting the anisotropy of electrical properties comprises replacing each of the segmented one or more anatomical regions with corresponding anisotropy of electrical properties.

In an embodiment, providing segmentation comprises segmentation of an image generated based on the magnetic resonance imaging data.

In an embodiment the magnetic resonance imaging data is two-dimensional imaging data. The magnetic resonance imaging data may however be three-dimensional imaging data.

In some embodiments the magnetic resonance imaging data is received by using spin-echo-based imaging sequence.

In some embodiments the magnetic resonance imaging data is received by using gradient-echo-based imaging sequence, which may comprise any one of balanced Fast Field Echo (bFFE) and Multi-Echo Steady-State (MESS) imaging sequences. In some embodiments the gradient-echo-based imaging sequence comprises any one of Ultrashort Echo Time (UTE) and Zero Echo Time (ZTE) imaging sequences.

Any of the embodiments may further comprise:

deriving diffusion anisotropy based on Diffusion Tensor Imaging (DTI) for the at least one portion of the body; and optionally,

outputting to the display screen diffusion anisotropy for the at least one portion of the body.

This embodiment may further comprise: generating an image based on a degree of congruence between the anisotropy of electrical properties and the diffusion anisotropy.

Any of the embodiments may further comprise:

deriving susceptibility anisotropy based on Susceptibility Tensor Imaging (STI) for the at least one portion of the body; and optionally,

outputting to the display screen diffusion anisotropy for the at least one portion of the body.

This embodiment may further comprise: generating an image based on a degree of congruence between the anisotropy of electrical properties and susceptibility anisotropy.

In any of the embodiments the electrical properties comprise at least one of conductivity and permittivity. In any of the embodiments the electrical properties may be displayed as conductivity map or permittivity map.

In a further aspect of the invention a system for electrical properties tomography imaging is provided, comprising a computational system configured to perform any of the method embodiments. The system may comprise a memory for storing machine executable instructions, wherein execution of the machine executable instructions causes the computational system to perform any of the method embodiments.

The system may further comprise a magnetic resonance imaging system for providing the magnetic resonance imaging data of the anatomy and a screen display configured to display the anisotropy of electrical properties.

In yet a further aspect of the invention a computer program is presented, comprising machine executable instructions, wherein execution of the machine executable instructions causes a computational system to perform any of the method embodiments.

Features described above with respect to method embodiments are applicable and are contemplated also for corresponding system embodiments, with similar benefits.

This Summary is provided to introduce a selection of concepts in a simplified form that are further described below in the Detailed Description. This Summary is not intended to identify key features or essential features of the claimed subject matter, nor is it intended to limit the scope of the claimed subject matter. A more extensive presentation of features, details, utilities, and advantages of the EPT system, as defined in the claims, is provided in the following written description of various embodiments of the disclosure and illustrated in the accompanying drawings.

## BRIEF DESCRIPTION OF THE DRAWINGS

Illustrative embodiments of the present disclosure will be described with reference to the accompanying drawings, of which:

Figure 1 illustrates an example of a medical system;
Figure 2 illustrates a further example of a medical system;
Figure 3 illustrates examples according to the invention;
Figure 4 illustrates an exemplary method according to the invention.

## DETAILED DESCRIPTION

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alteration and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

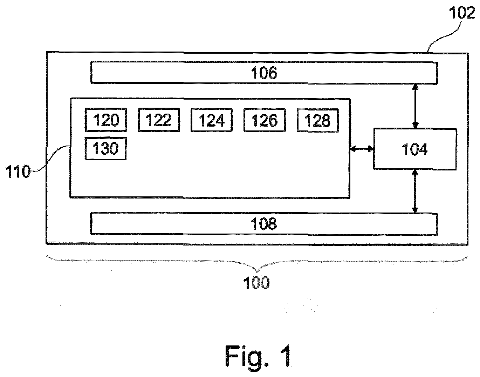

Fig. 1 illustrates an example of a system 100, which may be a medical system. In this example, the system comprises a computer 102. The computer 102 may represent one or more computer systems that are in one location or are distributed. The computer 102 is shown as including a computational system 104. The computational system 104 may for example be one or more processing cores that are located at one or more locations. The computational system 104 is shown as being connected to an optional hardware interface 106. The hardware interface 106 may for example be used to connect the computational system 104 with other components of the medical system 100 if they are present. The hardware interface 106 may enable the computational system 104 to control such components.

The computer 102 is further shown as comprising an optional user interface 108. The user interface 108 may for example be used by an operator to control the operation and function of the medical system 100. The medical system 100 could be a standalone computer system but it could also be integrated into a magnetic resonance imaging system.

The computer 102 is further shown as comprising a memory 110. The memory 110 is intended to represent any combination of memory or storage device which is accessible to the computational system 104. The memory 110 may include volatile and non-volatile memory storage means and components. The memory 110 in some embodiments may be based on or may rely on cloud-based data stored in logical pools across disparate, commodity storage servers located on premises or in a data center managed by a third-party cloud provider. Accordingly, the memory as schematically depicted in Fig. 1 is just for illustration purposes. Therefore, any or all components comprised in memory 110 may be cloud-based.

The memory 110 is shown as containing machine-executable instructions 120. The machine-executable instructions 120 may be configured to enable the computational system 104 to perform basic data processing and image processing tasks, such as reconstructing magnetic resonance images. The machine-executable instructions 120 may also in some examples contain code, which enables the computational system to control other components via the optional hardware interface 106.

The memory 110 may comprise image segmentation algorithm 122. The image segmentation algorithm 122 may be a standard magnetic resonance imaging image segmentation algorithm that is configured for outputting one or more predetermined anatomical regions for a magnetic resonance imaging data. This may be for a particular field of view or anatomical region of the subject, e.g., one or multiple anatomical structures or organs of a patient. In one of the examples the segmentation of the anatomical region is done based on the magnitude image of the balanced Fast Field Echo (bFFE) scan applied to acquire the B1 phase. In other embodiments the segmentation may be done based on an imaging sequence that samples multiple coherence pathways, which for example may be a Double-Echo Steady-State sequence (DESS), Triple-Echo Steady-State (TESS) sequence or any Multi-Echo Steady-State sequence (MESS).

The memory 110 may comprise or store the measured magnetic resonance imaging data 124. The memory 110 may further comprise an image segmentation 126 that has been received from the image segmentation algorithm 122 by inputting the measured magnetic resonance imaging data 124. The memory 110 may comprise a selected image portion 128. This is one or more regions or anatomical regions that have been identified in the image segmentation 126. The selected image portion 128 may for example be selected using a predetermined criterion that is applied to the image segmentation 126. The memory may comprise one or a plurality of various algorithms 130 for deriving electrical properties based on magnetic resonance imaging data 124 and by optionally using any information present in the memory 110 and/or information that may be input by a user through the user interface 108.

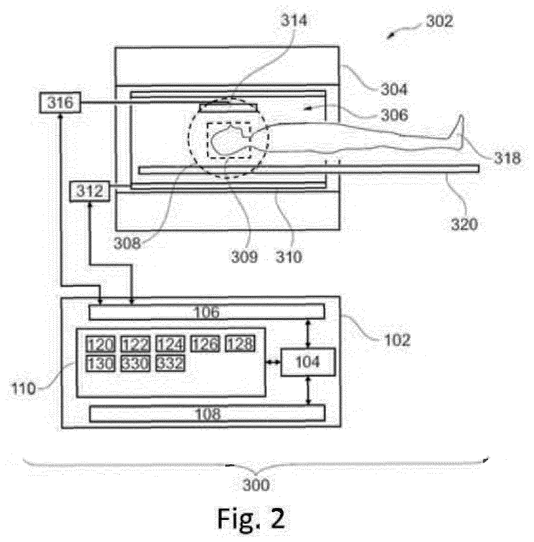

Fig. 2 illustrates a further example of a system 300, which may be a medical system. The medical system 300 comprises the medical system 100 illustrated in Fig. 1 and comprises a magnetic resonance imaging (MRI) system 302, or with other words a magnetic resonance imaging scanner, that is controlled by the computational system 104.

The magnetic resonance imaging system 302 comprises a magnet 304. The magnet 304 is a superconducting cylindrical-type magnet with a bore 306 through it. The use of different types of magnets is also possible; for instance, it is also possible to use both a split cylindrical magnet and a so-called open magnet. A split cylindrical magnet is similar to a standard cylindrical magnet, except that the cryostat has been split into two sections to allow access to the iso-plane of the magnet. Such magnets may for instance be used in conjunction with charged particle beam therapy. An open magnet has two magnet sections, one above the other with a space in-between that is large enough to receive a subject: the arrangement of the two sections is similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A region of interest 309 is shown within the imaging zone 308. Magnetic resonance data is typically acquired for the region of interest. A subject 318 is shown as being supported by a subject support 320 such that at least a portion of the subject 318 is within the imaging zone 308 and the region of interest 309.

Within the bore 306 of the magnet there is also a set of magnetic field gradient coils 310 which is used for acquisition of preliminary magnetic resonance data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308, there is a radio-frequency coil 314 for manipulating the orientations of magnetic spins within the imaging zone 308 and for receiving radio transmissions from spins also within the imaging zone 308. The radio-frequency coil may also be referred to as a channel or antenna. The radio frequency antenna may contain multiple coil elements. The radio-frequency coil 314 is connected to a radio frequency transceiver 316. The radio-frequency coil 314 and radio frequency transceiver 316 may be replaced by separate transmit and receive coils and a separate transmitter and receiver. It is understood that the radio-frequency coil 314 and the radio frequency transceiver 316 are representative. The radio-frequency coil 314 is intended to also represent a dedicated transmit antenna and a dedicated receive antenna. Likewise, the transceiver 316 may also represent a separate transmitter and receivers. The radio-frequency coil 314 may also have multiple receive/transmit elements and the radio frequency transceiver 316 may have multiple receive/transmit channels.

The transceiver 316 and the gradient controller 312 are shown as being connected to the hardware interface 106 of the computer system 102.

The memory 110 is shown as containing pulse sequence commands 330. The pulse sequence commands are commands or data which can be converted into commands that can be used to control the magnetic resonance imaging system 302 to acquire k-space data 332. An example of pulse sequence comprised by the pulse sequence commands 330 is bFFE. Other pulse sequences that facilitate EPT, such as DESS, TESS, MESS, etc., may alternatively or additionally be comprised in the pulse sequence commands 330, which may be uploaded in the memory 110. The memory 110 is further shown as comprising k-space data 332 that has been acquired by controlling the magnetic resonance imaging system 302 with the pulse sequence commands 330. The computational system 104 may also reconstruct the measured magnetic resonance imaging data 124 from the k-space data 332. EPT comprises the determination of one or both electric properties, conductivity and permittivity, and the invention is applicable to both, conductivity and permittivity. For the sake of simplicity, the following description is focused on conductivity $\sigma$ only, which can be reconstructed e.g., from the transceive phase $\varphi$ measured upon using for example a bFFE sequence. Phase-based EPT assumes a constant B1 magnitude and thus derives only the conductivity from the B1 phase. The extension of the invention to the full, complex version of EPT, wherein conductivity and permittivity are derived from both, B1 magnitude and B1 phase, is straightforward, because the equation for the permittivity contains the sum of second derivatives as it is for the conductivity in Eq. (1). Therefore, the splitting of Eq. (1) into the different parts as in Eq. (2.1) - Eq. (2.3) for conductivity is similar to that for permittivity.

Phase-based EPT derives the scalar conductivity $\sigma$ from the measured transceive phase $\varphi$ by the Laplacian $\Delta$:

$$\sigma = \Delta\varphi/(2\mu_0\omega) \equiv (\partial^2 x + \partial^2 y + \partial^2 z)\ \varphi/(2\mu_0\omega) \qquad \text{Eq. (1)}$$

wherein $\mu_0$ is the vacuum permeability and $\omega$ is the Larmor frequency of the respectively used MR system. To obtain information about anisotropy, three partial conductivities $\sigma_x$, $\sigma_y$, $\sigma_z$ are introduced:

$$\sigma_x \equiv \partial^2 x\ \varphi/(2\mu_0\omega) \qquad \text{Eq. (2.1)}$$

$$\sigma_y \equiv \partial^2 y\ \varphi/(2\mu_0\omega) \qquad \text{Eq. (2.2)}$$

$$\sigma_z \equiv \partial^2 z\ \varphi/(2\mu_0\omega) \qquad \text{Eq. (2.3)}$$

Hence, the scalar conductivity can be written as sum over partial conductivities (yielding the "total" conductivity):

$$\sigma = \sigma_x + \sigma_y + \sigma_z \qquad \text{Eq. (3)}$$

It is firstly, understood that:

- a current $j_x$ in x direction produces magnetic field components $B_y$ and $B_z$,
- a current $j_y$ in y direction produces magnetic field components $B_x$ and $B_z$,
- a current $j_z$ in z direction produces magnetic field components $B_x$ and $B_y$.

Secondly, it is understood that only $B_z$ contributes to a measurable change in the transceive phase $\varphi$, assuming a main magnetic field oriented along z. Thus, if tissue anisotropy forces local currents to predominantly flow in x or y direction, an increased $\sigma_z$ is expected. As it is thirdly, understood that the scalar ("total") conductivity is not changed by introducing anisotropy, an increased $\sigma_z$ is expected to cause a decreased $\varphi_x$ or $\varphi_y$, respectively.

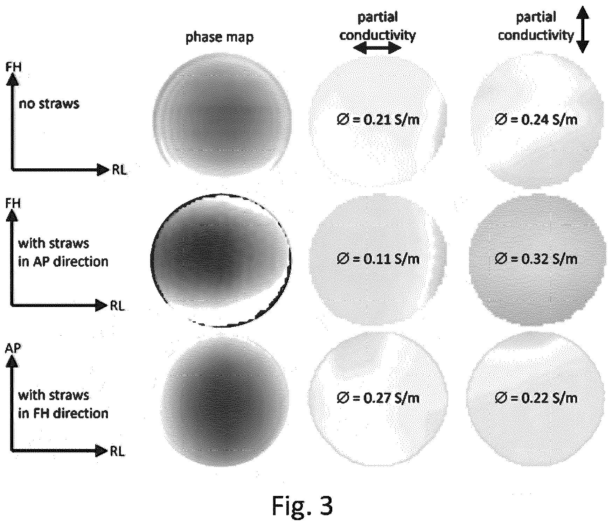

The method has been tested using saline-filled bottles without and with straws placed tightly-packed within and oriented along the longitudinal direction of the bottles, hence the direction of the straws is identical with the direction of the bottles. When the straws have been oriented in anterior-posterior (AP) direction (corresponding to the y direction), the phase in feet-head (FH) direction (corresponding to the *z* direction) shows a clearly higher curvature (i.e. higher second derivative) than in right-left (RL) direction. This difference in curvature leads to a clear difference in the partial conductivities as expected. Four control experiments have been performed: (i) with bottle oriented in AP direction but without straws, (ii) with straws oriented in FH direction, (iii) with straws oriented in RL direction, and (iv) with straws in AP direction. In experiment (i), illustrated in top row of Fig. 3, when the bottle is positioned in AP direction and it is without straws, similar partial conductivities have been obtained along directions because local currents are not forced in a specific direction. This is corresponding to an analogy of isotropic tissue. The partial conductivities are approximately equal, the ratio of the two partial conductivities is close to 1 (0.24 / 0.21). In experiment (ii), illustrated in the bottom row of Fig. 3, wherein the straws have been oriented in FH direction, similar partial conductivities have been obtained along directions, because the currents are forced in z direction, thus not changing $B_z$. The partial conductivities are approximately similar, the ratio of the two partial conductivities is close to 1 (0.27 / 0.22).

In experiment (iii) with straws in RL direction, not shown in Fig. 3, the partial conductivities obtained along directions showed similar results as the experiment with straws in AP direction, conform (iv). This is plausible as the experiments differ only by a rotation around the z axis, thus not changing the relation between directions of main field and straws. In experiment (iv) with straws in AP direction, illustrated in the middle row of Fig. 3, currents are forced to change $B_z$, which leads to strongly different partial conductivities (a ratio 0.32 / 0.11).

Since the phenomenon is caused by RF effects and not by gradients, the slice orientation has no effect on the conductivity results.

The approach has the ability to detect electrically anisotropic structures substantially perpendicular to the main field. Where possible, though not necessary, the approach would benefit if the examined body part can be rotated such that two scans can be performed, with the anisotropic structures parallel and orthogonal to the main magnetic field (e.g., muscles of forearm). There is no need that the angle $\theta$ between anisotropic structures and main field is exactly $\theta = 90°$. However, the closer $\theta$ to 90°, the larger the described effect, and the more reliable the diagnostic findings. This angle $\theta$ can typically be derived from corresponding anatomic images, preferably from the magnitude of the image where the B1 phase is taken from.

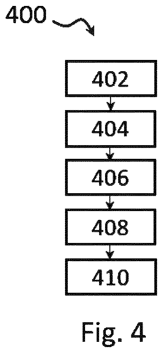

Fig. 4 shows a flowchart, which illustrates a method 400 of operating the medical system 100 illustrated in Fig. 1 or the medical system 300 of Fig. 2. The method may be computer-implemented. In step 402 magnetic resonance imaging data is received, for example based on a bFFE sequence. Furthermore, any spin-echo-based sequence may be used for providing the magnetic resonance imaging data, because its transceive phase does not contain the unwanted B0 phase component. Although Ultrashort Echo Time (UTE) and Zero Echo Time (ZTE), developed for imaging tissue with (very) short relaxation times, are based on gradient-echo sequences, they are also suitable for providing the magnetic resonance imaging data to carry out the invention, because the B0 phase component is in first order proportional to the echo time, and it is negligible for ultrashort/zero echo time. In other embodiments the invention can be performed based on imaging sequence that samples multiple coherence pathways, which for example may be a DESS sequence, Triple-Echo Steady-State (TESS) sequence, such as disclosed in European patent application No. EP23218953.0, which is hereby incorporated by reference in its entirety.

In step 402 an image, e.g., an anatomical image, may optionally be reconstructed or generated based on the magnetic resonance imaging data.

The calculation of conductivity $\sigma$ may benefit from a-priori knowledge of tissue boundaries conform the techniques used in Wang Y, Liu T, "Quantitative Susceptibility Mapping (QSM): Decoding MRI Data for a Tissue Magnetic Biomarker" Magnetic Resonance in Medicine 73:82-101(2015) and/or Katscher U, van den Berg CAT, "Electric properties tomography: Biochemical, physical and technical background, evaluation and clinical applications", NMR Biomed. (2017); e3729, hereby incorporated by reference in their entirety.

Segmentation of the anatomy of interest may be performed in step 404. This can be done, for example, based on the magnitude image of the bFFE scan applied to acquire the B1 phase. Alternatively, image segmentation can be performed with any segmentation technique known in the art that is applicable to magnetic resonance imaging data acquired with any of the hereinbefore mentioned sequences. In other examples the segmentation is performed based on a DESS sequence or a TESS sequence scan, wherein tissue boundaries can be extracted from the signal magnitude of one of the echoes. As the echo at TE$^+$ typically shows a higher signal to noise ratio (SNR) than the other echo(s), it is recommended to use this echo for tissue boundary extraction.

Tissue boundary determination can be improved by taking multiple magnitude images into account. For example, an edge detection algorithm, like the known Sobel or Canny algorithm, can be used and the results can be combined by straight-forward superposition or by locally weighted averaging.

In a further embodiment, the step of deriving tissue boundaries involves a segmentation of the magnitude image (or multiple magnitude images). A known segmentation technique may be employed, such as, e.g., deep learning (DL) based image segmentation, preferably using (regional) convolutional neuronal networks (CNN). Segmentation is the process of partitioning the magnitude image(s) into multiple regions that share similar attributes, thus yielding the boundaries between different tissue types (healthy tissue vs. suspicious/cancerous tissue). Image segmentation has recently become the biggest target for DL approaches in medical imaging. MR image segmentation using DL, typically CNNs, has been proposed in almost the whole field of applications, whereof breast and brain tumor segmentation are only examples.

Subsequently, in step 406 the anisotropic electrical properties are derived from the magnetic resonance imaging data. For example, the three partial conductivities $\sigma_x, \sigma_y, \sigma_z$ can be derived based on Eq. (2.1) - Eq. (2.3). In similar manner the partial permittivities can be derived from magnetic resonance imaging data that comprises both, B1 magnitude and B1 phase. This is straightforward because the equation for the permittivity contains the sum of second derivatives as it is for the conductivity in Eq. (1). Thus, the splitting of Eq. (1) into the different parts as in Eq. (2.1) - Eq. (2.3) is the similar for conductivity and permittivity.

In an additional embodiment the so called total or scalar conductivity and/or permittivity can be computed as sum over partial conductivities.

In step 408 the anisotropic electrical properties are output to a user interface, such as for example a screen display. The representation of the anisotropic electrical properties may be side-by-side to the corresponding anatomical image and/or may be overlayed on the anatomical image derived from the magnetic resonance imaging data, such that anisotropic electrical properties are represented over the corresponding anatomical structures. Additionally, the total electrical properties may be represented in a separate image.

Color-coding of the partial electrical properties according to the directions may be an optional embodiment, which color-coding may be similar to that implemented in Diffusion Tensor Imaging (DTI).

In an embodiment the partial conductivities $\sigma_x, \sigma_y, \sigma_z$ are represented with different colors and their values are represented by various intensities of the respective colors. Similar embodiments are envisaged also for representation of partial permittivities. Color-bars representing colors and intensities may be output, corresponding to the scale of values of electrical properties presented in the generated image.

The invention complements the electrophysiologic depiction of fibrous tissue, and thus provides improved diagnostic potential in many neurologic and musculoskeletal applications. A particular application benefit is conferred for clinical application wherein the electrical anisotropy may be compared with diffusion anisotropy of DTI. Therefore, in an optional step 410, diffusion anisotropy may be represented along or side by side with the anisotropy of the electrical properties. In further additional or alternative embodiment the computational system may be configured to provide a comparison of electrical anisotropy with diffusion anisotropy either by outputting values on a display screen or by outputting a separate representation of the comparison result associated to the anatomical structure of interest or overlaid on the anatomical image derived from the magnetic resonance imaging data. Additionally or alternatively, an image may be generated based on a degree of congruence between the anisotropy of electrical properties and diffusion anisotropy. The degree of congruence may be expressed in values or in colormaps attributed to deviation of anisotropy of electrical properties from diffusion anisotropy, such that a larger value or a more distinct color from the colormap corresponds to a larger deviation of the anisotropy of electrical properties from the diffusion anisotropy. Accordingly, there may be portions of the anatomical structure where the congruence is larger (i.e. the trend of anisotropy of electrical properties is similar to that of the diffusion anisotropy) and where the congruence is lower (i.e. the trend of anisotropy of electrical properties is significantly dissimilar to that of the diffusion anisotropy).

In clinical practice it is expected that electrical anisotropy and diffusion anisotropy show congruence in healthy tissue, with inherent consequence that incongruence indicates abnormal tissue state.

In yet a further alternative or additional embodiment the computational system may be configured to provide a comparison of electrical anisotropy with susceptibility anisotropy either by outputting values on a display screen or by outputting a separate representation of the comparison result associated to the anatomical structure of interest or overlaid on the anatomical image derived from the magnetic resonance imaging data. Additionally or alternatively, an image can be generated based on a degree of congruence between the anisotropy of electrical properties and susceptibility anisotropy. Susceptibility anisotropy can be derived through Susceptibility Tensor Imaging based on Liu, C., "Susceptibility tensor imaging", Magnetic Resonance in Medicine 63:1471-1477 (2010); https://doi.org/10.1002/mrm.22482, which is hereby incorporated by reference in its entirety. The degree of congruence may be expressed in values or in colormaps, similar to the embodiments described with respect to congruence between the anisotropy of electrical properties and diffusion anisotropy.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a magnetic hard disk drive, a solid state hard disk, flash memory, a USB thumb drive, Random Access Memory (RAM), Read Only Memory (ROM), an optical disk, a magneto-optical disk, and the register file of the computational system. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special-purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen.

All directional references e.g., upper, lower, inner, outer, upward, downward, left, right, lateral, front, back, top, bottom, above, below, vertical, horizontal, clockwise, counterclockwise, proximal, and distal are only used for identification purposes to aid the reader's understanding of the claimed subject matter, and do not create limitations, particularly as to the position, orientation, or use of the reinforced multi-filar conductor bundle. Connection references, e.g., attached, coupled, connected, and joined are to be construed broadly and may include intermediate members between a collection of elements and relative movement between elements unless otherwise indicated. As such, connection references do not necessarily imply that two elements are directly connected and in fixed relation to each other. The term "or" shall be interpreted to mean "and/or" rather than "exclusive or." The word "comprising" does not exclude other elements or steps, and the indefinite article "a" or "an" does not exclude a plurality. Unless otherwise noted in the claims, stated values shall be interpreted as illustrative only and shall not be taken to be limiting.

Although various embodiments of the claimed subject matter have been described above with a certain degree of particularity, or with reference to one or more individual embodiments, those skilled in the art could make numerous alterations to the disclosed embodiments without departing from the spirit or scope of the claimed subject matter.

Still other embodiments are contemplated. It is intended that all matter contained in the above description and shown in the accompanying drawings shall be interpreted as illustrative only of particular embodiments and not limiting. Changes in detail or structure may be made without departing from the basic elements of the subject matter as defined in the following claims.

**Claims**

1. A method (400) of electrical properties tomography imaging, comprising:

   receiving (402) magnetic resonance imaging data (124) of at least one portion of a body;
   deriving (406) partial electrical properties based on the magnetic resonance imaging data;
   outputting (408) to a display screen anisotropy of electrical properties for the at least one portion of the body based on the partial electrical properties.

2. The method of claim 1, further comprising:

providing (404) an image segmentation (126) comprising one or more anatomical regions within the magnetic resonance imaging data in response to inputting the magnetic resonance imaging data into an image segmentation algorithm;

wherein outputting the anisotropy of electrical properties is for the provided image segmentation.

3. The method of claim 2, wherein outputting the anisotropy of electrical properties comprises replacing each of the segmented one or more anatomical regions with corresponding anisotropy of electrical properties.

4. The method of any of the preceding claims, wherein providing segmentation comprises segmentation of an image generated based on the magnetic resonance imaging data.

5. The method of any of the preceding claims, wherein the magnetic resonance imaging data is two-dimensional imaging data.

6. The method of any of the claims 1 to 4, wherein the magnetic resonance imaging data is three-dimensional imaging data.

7. The method of any of the preceding claims, wherein the magnetic resonance imaging data is received based on spin-echo imaging sequence.

8. The method of any of the claims 1 to 6, wherein the magnetic resonance imaging data is received based on gradient-echo imaging sequence.

9. The method of claim 8, wherein the gradient-echo imaging sequence comprises any one of balanced Fast Field Echo, Multi-Echo Steady-State, Ultrashort Echo Time and Zero Echo Time imaging sequences.

10. The method of any of the preceding claims, further comprising:

deriving diffusion anisotropy based on Diffusion Tensor Imaging for the at least one portion of the body; and/or
deriving susceptibility anisotropy based on Susceptibility Tensor Imaging for the at least one portion of the body.

11. The method of claim 10, further comprising:

generating an image based on a degree of congruence between the anisotropy of electrical properties and the diffusion anisotropy; and/or
generating an image based on a degree of congruence between the anisotropy of electrical properties and susceptibility anisotropy.

12. The method of any of the preceding claims, wherein the electrical properties comprise at least one of conductivity and permittivity.

13. A system (100, 300) for electrical properties tomography imaging, comprising:
a computational system (104) configured to perform a method according to any of the claims 1 to 12.

14. The system of claim 13, further comprising:

a magnetic resonance imaging system for providing the magnetic resonance imaging data of the anatomy;
a display screen configured to display the anisotropy of electrical properties.

15. A computer program comprising machine executable instructions, wherein execution of the machine executable instructions causes a computational system to perform a method according to any of the claims 1 to 12.

Fig. 1

EP 4 607 229 A1

Fig. 2

Fig. 3

400

402

404

406

408

410

Fig. 4

**EUROPEAN SEARCH REPORT**

Application Number

EP 24 15 9011

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SEKINO MASAKI ET AL: "Conductivity tensor imaging of the brain using diffusion-weighted magnetic resonance imaging", JOURNAL OF APPLIED PHYSICS, AMERICAN INSTITUTE OF PHYSICS, 2 HUNTINGTON QUADRANGLE, MELVILLE, NY 11747, vol. 93, no. 10, 15 May 2003 (2003-05-15), pages 6730-6732, XP012057944, ISSN: 0021-8979, DOI: 10.1063/1.1544446 | 1,5-15 | INV. G01R33/56 <br><br> ADD. G01R33/48 G01R33/561 G01R33/563 |
| A | * page 1 - page 2; figure 3 * | 2-4 | |
| X | US 2018/085026 A1 (KANEKO YUKIO [JP] ET AL) 29 March 2018 (2018-03-29) | 1,5-15 | |
| A | * paragraphs [0062] - [0071], [0076] - [0098]; figures 7, 11, 12 * | 2-4 | |
| X | SAJIB SAURAV Z ET AL: "Electrodeless conductivity tensor imaging (CTI) using MRI: basic theory and animal experiments", BIOMEDICAL ENGINEERING LETTERS, THE KOREAN SOCIETY OF MEDICAL AND BIOLOGICAL ENGINEERING, KOREA, vol. 8, no. 3, 25 April 2018 (2018-04-25), pages 273-282, XP036556369, ISSN: 2093-9868, DOI: 10.1007/S13534-018-0066-3 [retrieved on 2018-04-25] | 1,5-15 | TECHNICAL FIELDS SEARCHED (IPC) <br><br> G01R |
| A | * page 274 - page 279; figures 1, 2 * | 2-4 | |
| X | US 2016/055304 A1 (RUSSELL MICHAEL J [US] ET AL) 25 February 2016 (2016-02-25) * paragraph [0101] - paragraph [0122]; figure 13A * | 1-15 | |

The present search report has been drawn up for all claims

| Place of search | Date of completion of the search | Examiner |
|---|---|---|
| Munich | 3 July 2024 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 15 9011

This annex lists the patent family members relating to the patent documents cited in the above-mentioned European search report.
The members are as contained in the European Patent Office EDP file on
The European Patent Office is in no way liable for these particulars which are merely given for the purpose of information.

03-07-2024

| Patent document cited in search report | | Publication date | Patent family member(s) | | Publication date |
|---|---|---|---|---|---|
| US 2018085026 | A1 | 29-03-2018 | JP | 6615079 B2 | 04-12-2019 |
| | | | JP | 2018051009 A | 05-04-2018 |
| | | | US | 2018085026 A1 | 29-03-2018 |
| US 2016055304 | A1 | 25-02-2016 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 23218953

**Non-patent literature cited in the description**

- **LEIJSEN R. et al.** Electrical Properties Tomography: A Methodological Review. *Diagnostics*, 2021, vol. 11, 176, https://doi.org/10.3390/diagnostics11020176
- **WANG Y** ; **LIU T**. Quantitative Susceptibility Mapping (QSM): Decoding MRI Data for a Tissue Magnetic Biomarker. *Magnetic Resonance in Medicine*, 2015, vol. 73, 82-101
- **KATSCHER U** ; **VAN DEN BERG CAT**. Electric properties tomography: Biochemical, physical and technical background, evaluation and clinical applications. *NMR Biomed.*, 2017, e3729
- **LIU, C.** Susceptibility tensor imaging. *Magnetic Resonance in Medicine*, 2010, vol. 63, 1471-1477, https://doi.org/10.1002/mrm.22482